# EUROPEAN PATENT APPLICATION

(11) **EP 1 020 988 A1**
(43) Date of publication of application: **19.07.2000**
(21) Application number: 97943143.4
(22) Date of filing: 02.10.1997
(51) Int. Cl.: H02P 9/30

(54) **VOLTAGE REGULATING DEVICE**

(71) Applicant: MITSUBISHI DENKI KABUSHIKI KAISHA, Tokyo 100 (JP)
(72) Inventor: IWATANI, Shiro, Mitsubishi Denki Kabushiki Kaisha, Chiyoda-ku Tokyo 100 (JP); GODA, Tsuneji, Mitsubishi Denki Kabushiki Kaisha, Chiyoda-ku Tokyo 100 (JP)
(74) Representative: HOFFMANN - EITLE
(86) International application number: JP9703532
(87) International publication number: WO9918656

(57) **Abstract**

A voltage adjusting device is applied to a control device using the same circuit substrate for a first voltage system and a second voltage system having an operating voltage higher than that in the first voltage system. The circuit substrate is commonly used for the first voltage system and the second voltage system. A plurality of resistors (301c, 301d, 301e, 301f) printed on the circuit substrate which forms the control device are connected in parallel or series with each other between a plurality of conductors (A1, A2, A3) on the hybrid integrated circuit substrate. When the plurality of resistors are used for the first voltage system, the plurality of resistors are used in a parallel or series connection state, and when the plurality of resistors are used for the second voltage system, the plurality of resistors are used in a state where at least one of the resistors is cut or in a state where a part of connection conductors connecting between the plurality of conductors is cut.

## Description

### TECHNICAL FIELD

The present invention relates to voltage adjusting devices which are identical in their circuit structure but different in operating voltages from each other. More particularly, it relates to a control device for an A.C. generator for use in a vehicle, for example.

### BACKGROUND ART

Up to now, as for voltage adjusting devices which are identical in their circuit structures but different in operating voltages, there has been known a control device for a vehicle A.C. generator. However, in the voltage adjusting devices of this type, there is a case in which only voltage systems (that is, operating voltages) are different even if the circuit structures are substantially identical. In this case, the respective dedicated circuit substrates such as hybrid integrated circuit substrates are manufactured in conformity with required operating voltages even if the circuit structures are substantially identical with each other, in order to cope with such different voltage systems.

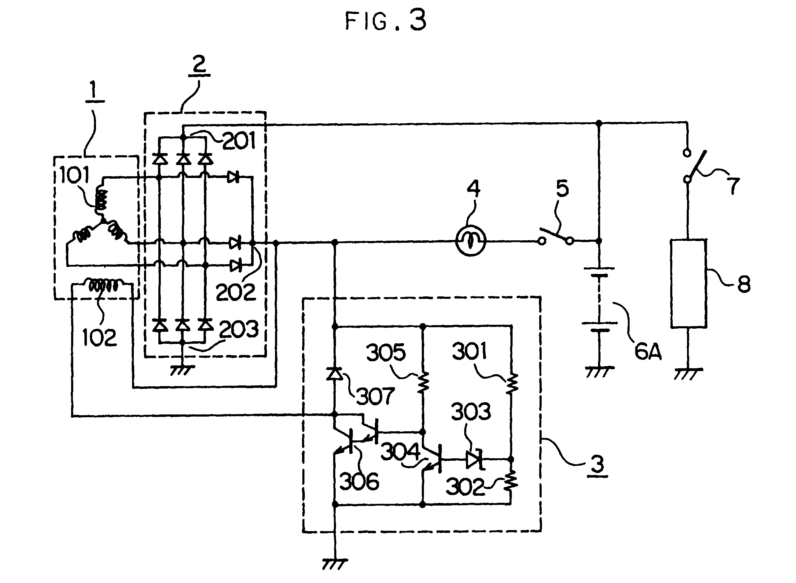

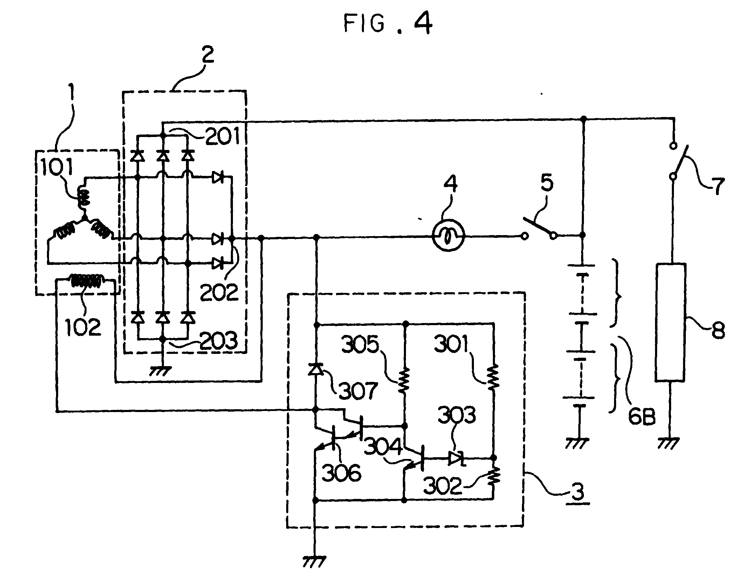

For example, a control circuit for a vehicle A.C. generator, as shown in Fig. 3, corresponds to a first voltage system (for example, an operating voltage of 12V), and a control circuit for a vehicle A.C. generator as shown in Fig. 4 is employed for a second voltage system (for example, 24V), the operating voltage of which is different from that of the first voltage system. The above control circuit for the vehicle A.C. generator is disclosed in, for example, Japanese Patent Application Laid-Open No. Sho 62-104500.

The control circuit shown in Fig. 3 will be described. Reference numeral 1 denotes a three-phase A.C. generator having an armature coil 101 and a field coil 102. The armature coil 101 of the A.C. generator 1 is connected with a full-wave rectifier 2 having a plurality of diodes, and the full-wave rectifier 2 includes a positive output terminal 201, an auxiliary rectification output terminal 202 and a negative output terminal 203. The positive output terminal 201 of the full-wave rectifier 2 is connected to an electric load 8 through a load switch 7. A storage battery 6A, which is a chargeable power supply, is connected in parallel with the load switch 7 and the electric load 8, and the positive electrode side of the storage battery 6A is connected to the positive output terminal 201 of the full-wave rectifier 2, and also connected to the auxiliary rectification output terminal 202 of the full-wave rectifier 2 through a key switch 5 and a charge indicator lamp 4. The storage battery 6A is adapted to apply a D.C. voltage of 6 V. A voltage adjusting device 3 is connected between the field coil 102 of the A.C. generator 1 and the storage battery 6A. Specifically, one end of the voltage adjusting device 3 is connected to one end of the field coil 102, and the other end of the voltage adjusting device 3 is connected to the other end of the field coil 102 and also connected to an electric path or wiring between the auxiliary rectification output terminal 202 of the full-wave rectifier 2 and the charge indicator lamp 4.

The voltage adjusting device 3 includes potential division resistors 301 and 302 for voltage detection which are connected in series to each other, a Zener diode one end of which is connected to a node between the voltage detection potential division resistors 301 and 302 and the other end of which is connected to a base of a transistor 304, and a base resistor 305 one end of which is connected to the collector of the transistor 304 and the other end of which is connected to the voltage detection potential division resistor 301 and an electric path or wiring between the auxiliary rectification output terminal 202 of the full-wave rectifier 2 and the charge indicator lamp 4. The voltage adjusting device 3 also includes a power transistor 306 for field current supply/interruption, and a suppression diode 307 for absorption of field coil surges. The power transistor 306 for field current supply/interruption and the suppression diode 307 for absorption of field coil surges are connected in series to each other between ground and the electric wiring connecting between the auxiliary rectification output terminal 202 of the full-wave rectifier 2 and the charge indicator lamp 4. One end of the field coil 102 is connected to a node of the power transistor 306 and the suppression diode 307, and a base of the power transistor 306 is connected to a node between the base resistor 305 and the collector of the transistor 304.

Also, the control device shown in Fig. 4 is nearly identical with the control device shown in Fig. 3 only excepting that the voltage of the storage battery 6B, which is a chargeable power supply, is 12 V.

Subsequently, the operation of the control device shown in Fig. 3 will be described. When the key switch 5 is closed upon starting an engine (not shown), an initial exciting current flows in the field coil 102 of the A.C. generator 1 through the key switch 5 so that the A.C. generator 1 can generate electric power. Then, when the engine (not shown) is started, the A.C. generator 1 is driven to rotate by the engine, starting power generation. As a result, the voltage adjusting device 3 inputs the output voltage from the auxiliary rectification output terminal 202 of the rectifier 2, and if the output voltage exceeds a given value which is predetermined by the voltage detection potential division resistors 301, 302 and the Zener diode 303, the Zener diode 303 is first rendered conductive and then the transistor 304 conductive.

Also, when the above output voltage becomes equal to or less than the given value, the Zener diode 303 is first rendered nonconductive, and then the transistor 304 nonconductive.

The on/off operation of the power transistor 306 is controlled by the above conduction/nonconduction of the transistor 304, and the output voltage of the generator 1 is adjusted to a given value by turning on/off the field coil 102 of the generator 1. In this way, the voltage adjusting device 3 repeats the above operation regardless of the state of the generator 1, and the generator 1 supplies electric power to the storage battery 6A and the electric load 8 from the output terminal 201 of the rectifier 2 with its output voltage adjusted.

The same is applicable to the operation of the control device shown in Fig. 4.

Figs. 5(a) and 5(b) show examples of conventional devices in the case where the above voltage adjusting device 3 is constructed by a hybrid integrated circuit substrate, in particular, with a part of the voltage detection potential division resistor 301 being illustrated on an enlarged scale. Fig. 5(a) shows a first voltage system (for example, 12 V), and Fig. 5(b) shows a second voltage system (for example, 24 V). In those figures, symbols A1 and A2 denote printed conductors on a circuit substrate which are isolated from each other, and a symbol 301a denotes a resistor of 20 KΩ connected between the printed conductors A1 and A2, and a symbol 301b denotes a resistor of 40 KΩ likewise connected between the printed conductors A1 and A2, respectively.

In the case of the conventional device thus constructed, since the control voltage systems are different from each other, for example, 12 V and 24 V, the resistant values of the respective resistors are different from each other regardless of the structures of both the control circuits being identical. For that reason, the respective dedicated hybrid integrated circuit substrates are provided for the respective control voltage systems so as to cope with the above problem.

Accordingly, for the two different control voltage systems, two sorts of circuit substrates such as the hybrid integrated circuit substrates are required in correspondence to the respective voltage systems even if they are of the same circuit structure. This causes such a problem that the number of types in the entire product group increases, and the manufacturing costs jump.

In view of the above, the present invention is intended to eliminate the above-described conventional problems, and therefore has an object to provide a voltage adjusting device which is capable of coping with the plural control voltage systems by only using one sort of circuit substrate and hence capable of reducing the manufacturing costs.

### DISCLOSURE OF THE INVENTION

The present invention is to provide an inexpensive voltage adjusting device having substantially the same circuit structure which is readily applicable to a plurality of voltage systems different in operating voltages.

According to one aspect of the present invention, there is provided a voltage adjusting device having the same circuit substrate for a first voltage system and a second voltage system which has an operating voltage higher than that in the first voltage system, comprising: a circuit substrate on which an electric circuit for control is formed; a plurality of conductors formed on the circuit substrate; and a plurality of resistors connected to the plurality of conductors. The plurality of conductors and the plurality of resistors are used so as to be partially selectively cut or not cut at all in accordance with the requirements of the first voltage system or the second voltage system so as to change the total resistant value of the plurality of resistors connected between the plurality of conductors, whereby the circuit substrate can be commonly used for the first voltage system and the second voltage system.

In one preferred form of the present invention, the plurality of resistors are connected in parallel with each other between the plurality of conductors, and the resistors are used in a parallel connection state without being cut when the plurality of resistors are used for the first voltage system, whereas the plurality of resistors are used in a state where at least one of the resistors is cut when the plurality of resistors are used for the second voltage system.

In another preferred form of the present invention, the plurality of resistors are connected in parallel with each other between the plurality of conductors, and the conductors are used without being cut when the plurality of conductors are used for the first voltage system, whereas the plurality of conductors are used in a state where at least a part of the conductors is cut so that the plurality of resistors are partially invalidated when the plurality of conductors are used for the second voltage system.

In still another preferred form of the present invention, the plurality of resistors are connected in series with each other between the plurality of conductors, the plurality of conductors are partially electrically connected to each other by connection conductors so as to partially electrically short-circuit the plurality of resistors, whereas the connection conductors are used without being cut when the connection conductors are used for the first voltage system, but the connection conductors are used in a state where at least a part of the connection conductors is cut when the connection conductors are used for the second voltage system.

According to another aspect of the present invention, there is provided a voltage adjusting device in which an output voltage of an A.C. generator for charging a storage battery is adjusted to a given value by intermittently controlling a field current that flows through a field coil of the A.C. generator, the voltage adjusting device comprising: a common circuit substrate for a first voltage system and a second voltage system which has an operating voltage higher than that in the first voltage system; and a plurality of resistors printed on a circuit substrate on which an electric circuit for control is formed, the resistors being connected in parallel with each other between a plurality of conductors on the circuit substrate. The plurality of resistors are used in a parallel connection state without being cut when the plurality of resistors are used for the first voltage system, whereas the plurality of resistors are used in a state where at least one of the resistors is cut when the plurality of resistors are used for the second voltage system so that the circuit substrate can be commonly used for the first voltage system and the second voltage system.

According to still another aspect of the present invention, there is provided a voltage adjusting device in which an output voltage of an A.C. generator for charging a storage battery is adjusted to a given value by intermittently controlling a field current that flows in a field coil of the A.C. generator, the voltage adjusting device comprising: a common circuit substrate for a first voltage system and a second voltage system which has an operating voltage higher than that in the first voltage system; and a plurality of resistors printed on the common circuit substrate on which an electric circuit for control is formed, the resistors being connected in series with each other between a plurality of conductors on the circuit substrate, the plurality of conductors being partially electrically connected by connection conductors. The plurality of conductors are used in a series connection state without the connection conductors being cut when the plurality of conductors are used for the first voltage system, whereas the plurality of conductors are used in a state where at least a part of the connection conductors is cut when the plurality of conductors are used for the second voltage system so that the circuit substrate can be commonly used for the first voltage system and the second voltage system.

The above or other objects, features and advantages of the present invention will become apparent from the detailed description of the invention which will be described below with reference to the accompanying drawings.

### BRIEF DESCRIPTION OF THE DRAWINGS

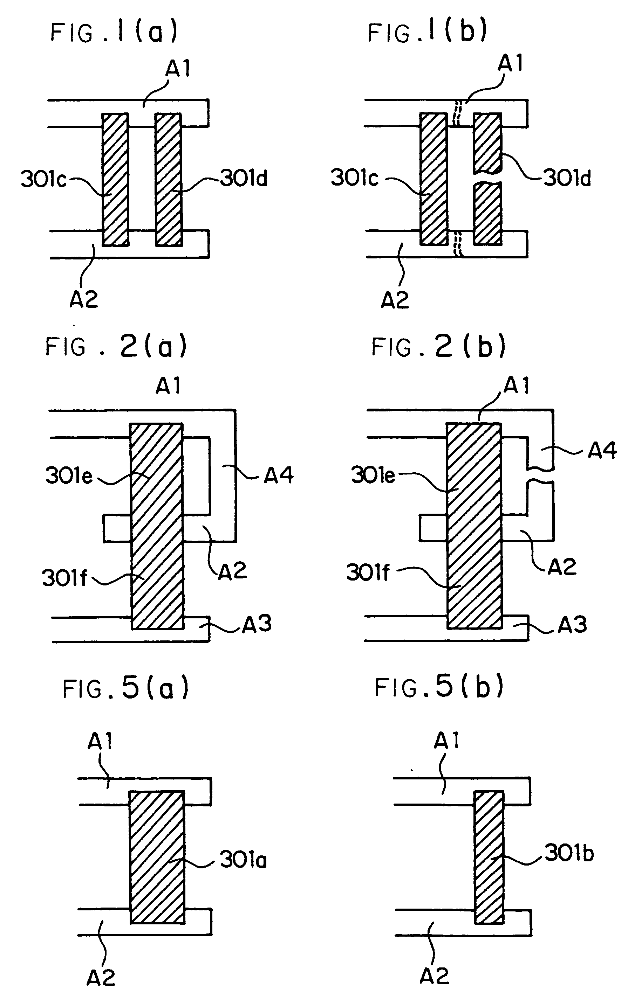

Figs. 1(a) and 1(b) show a voltage adjusting device in accordance with embodiment 1 of the present invention, in which Fig. 1(a) shows a case where the voltage adjusting device is applied to a first voltage system (for example, 12 V), and Fig. 1(b) shows a case where the voltage adjusting device is applied to a second voltage system (for example, 24 V).
Figs. 2(a) and 2(b) show a voltage adjusting device in accordance with embodiment 2 of the present invention, in which Fig. 2(a) shows a case where the voltage adjusting device is applied to a first voltage system (for example, 12 V), and Fig. 2(b) shows a case where the voltage adjusting device is applied to a second voltage system (for example, 24 V).
Fig. 3 shows an electric circuit diagram of a conventional control circuit for a vehicle A.C. generator for a first voltage system to which the voltage adjusting device of the present invention can be applied.
Fig. 4 shows an electric circuit diagram of a conventional control circuit for a vehicle A.C. generator for a second voltage system to which the voltage adjusting device of the present invention can be applied.
Figs. 5(a) and 5(b) show a conventional voltage adjusting device, in which Fig. 5(a) shows a case where the voltage adjusting device is applied to a first voltage system (for example, 12 V), and Fig. 5(b) shows a case where the voltage adjusting device is applied to a second voltage system (for example, 24 V).

### BEST MODES FOR CARRYING OUT THE INVENTION

The present invention will be described in detail with reference to the accompanying drawings. In the embodiments of the present invention which will be described hereinafter, the same members as those of the above conventional example in Figs. 5(a) and 5(b) are represented by identical references.

### Embodiment 1

Figs. 1(a) and 1(b) representatively show a potential division resistor portion of a hybrid integrated circuit substrate in a voltage adjusting device in accordance with embodiment 1 in the case where the present invention is applied to the above control device for the vehicle A.C. generator shown in Figs. 3 and 4.

Fig. 1(a) shows a case in which the hybrid integrated circuit according to the embodiment 1 of the present invention is applied to the control device for the vehicle A.C. generator for the first voltage system (for example, 12V). In the figure, symbols 301c and 301d denote resistors having the same resistance value (for example, 40 KΩ). Those resistors 301c and 301d, which are disposed in parallel with each other, are connected at both ends thereof to two printed conductors A1 and A2 which are isolated from each other and serve as conductors. Accordingly, the composite resistant value of the resistors 301c and 301d between the two printed conductors A1 and A2 is 20 KΩ.

Fig. 1(b) shows a case in which the hybrid integrated circuit according to the embodiment 1 of the present invention is applied to a control device for a vehicle A.C. generator for the second voltage system (for example, 24 V). In this example, one 301d of the two resistors 301c and 301d is cut or deleted by a laser beam or the like. In this case, the resistance value between the printed conductors A1 and A2 becomes 40 KΩ which is caused by only the resistor 301c which is not cut.

Also, the above description is given of a case in which two resistors are used. However, using a circuit substrate on which three or more resistors are connected in parallel with each other between the printed conductors A1 and A2, at least one of the plural resistors may be cut in accordance with a required voltage.

Further, if required, as indicated by corrugated lines in Fig. 1(b), parts of the printed conductors A1 and A2 are cut instead of the resistors 301d being cut so as to invalidate the resistor 301d.

With the above structure, the same circuit substrate of one sort can be used even in different voltage systems, and it is unnecessary to manufacture specific circuit substrates of many sorts corresponding to the respective voltage systems as in the conventional example, thereby making it possible to reduce the manufacturing costs.

### Embodiment 2

Figs. 2(a) and 2(b) representatively show a potential division resistor portion of a hybrid integrated circuit substrate in a voltage adjusting device in accordance with embodiment 2 in the case where the present invention is applied to the above control device for the vehicle A.C. generator shown in Figs. 3 and 4.

Fig. 2(a) shows a case in which the hybrid integrated circuit according to the embodiment 2 of the present invention is applied to the control device for the vehicle A.C. generator for the first voltage system (for example, 12 V). In the figure, symbols 301e and 301f denote resistors having the same resistance value (for example, 20 KΩ). Those resistors 301c and 301d are connected in series with each other, and are integrally formed with each other in the example shown in the figure. These resistors 301c and 301d are connected in series with three printed conductors A1, A2 and A3 which are disposed in parallel with each other and serve as conductors. That is, the resistor 301e is connected between the printed conductors A1 and A2, the resistor 301f is connected between the printed conductors A2 and A3, and the printed conductors A1 and A2 are integrally connected with each other by a printed conductor A4 which serves as a connection conductor. Accordingly, in this case, since the resistor 301e is electrically short-circuited by the printed conductor A4 connected between the printed conductors A1 and A2, the resistance value between the printed conductors A1 and A2 becomes 20 KΩ, which is the resistance value of only the resistor 301f.

Fig. 2(b) shows a case in which the hybrid integrated circuit according to the embodiment 2 of the present invention is applied to the control device for the vehicle A.C. generator for the second voltage system (for example, 24 V). In this example, the printed conductor A4 connected between the printed conductors A1 and A2 is cut or deleted by a laser beam or the like. In this case, the resistant value between the printed conductors A1 and A3 becomes 40 KΩ, which is the combined resistance values of the resistors 301e and 301f connected in series.

The embodiment 2 shows a case in which the resistors 301e and 301f are connected in series between the three printed conductors A1, A2 and A3. However, a plurality of resistors may be connected in series between four or more printed conductors so that at least one printed conductor (that is, the appropriate number of printed conductors) connected between the printed conductors may be cut in accordance with a required voltage.

Similarly, the embodiment 2 can attain the same merits as those in the above embodiment 1.

The above description has been given of a case in which the present invention is applied to the resistor 301 of the control circuit 3 in the above conventional device shown in Figs. 3 and 4. Likewise, the present invention can be applied to the resistor 302 and the resistor 305.

Also, the above description has been given of a case in which the present invention is applied to the control device for the vehicle A.C. generator. However, the present invention is not limited to such as case but applicable to another control device having the same circuit and different voltage systems, likewise, with the same merits as those described above.

As described above, according to the present invention, even in the case where the control voltage systems are different, the same circuit substrate can be used if the same circuit structure is applied. Consequently, one sort of circuit substrates may be manufactured for different voltage systems, as the result of which the number of types of the entire product group can be minimized, and the manufacturing costs can be reduced.

Also, since the circuit substrate of the present invention can be adapted to different voltage systems by merely cutting or short-circuiting a part of the circuit, circuit designing becomes easy.

Further, in the case where the circuit substrate is commonly used for the voltage systems having voltage doubler such as 12 V/24 V, the same resistors may be disposed in parallel or in series, with the result that circuit designing and voltage adjustments become easy.

## Claims

1. A voltage adjusting device (3) having the same circuit substrate for a first voltage system and a second voltage system which has an operating voltage higher than that in the first voltage system, comprising:
a circuit substrate on which an electric circuit for control is formed;
a plurality of conductors (A1, A2, A3) formed on said circuit substrate; and
a plurality of resistors (301c, 301d, 301e, 301f) connected to said plurality of conductors;
wherein said plurality of conductors and said plurality of resistors are used so as to be partially selectively cut or not cut at all in accordance with the requirements of said first voltage system or said second voltage system so as to change the total resistant value of said plurality of resistors connected between said plurality of conductors, whereby said circuit substrate can be commonly used for said first voltage system and said second voltage system.

2. The voltage adjusting device as claimed in claim 1, wherein said plurality of resistors (301c, 301d) are connected in parallel with each other between said plurality of conductors, and wherein said resistors are used in a parallel connection state without being cut when said plurality of resistors are used for said first voltage system, whereas said plurality of resistors are used in a state where at least one (301d) of said resistors is cut when said plurality of resistors are used for said second voltage system.

3. The voltage adjusting device as claimed in claim 1, wherein said plurality of resistors (301c, 301d) are connected in parallel with each other between said plurality of conductors, and wherein said conductors are used without being cut when said plurality of conductors are used for said first voltage system, whereas said plurality of conductors are used in a state where at least a part of said conductors (A1, A2) is cut so that said plurality of resistors are partially invalidated when said plurality of conductors are used for said second voltage system.

4. The voltage adjusting device as claimed in claim 1, wherein said plurality of resistors (301e, 301f) are connected in series with each other between said plurality of conductors (A1, A2, A3), and wherein said plurality of conductors are partially electrically connected to each other by connection conductors (A4) to partially electrically short-circuit said plurality of resistors, whereas said connection conductors are used without being cut when said connection conductors are used for said first voltage system, but said connection conductors are used in a state where at least a part of said connection conductors (4A) is cut when said connection conductors are used for said second voltage system.

5. A voltage adjusting device (3) in which an output voltage of an A.C. generator (1) for charging a storage battery (6A) is adjusted to a given value by intermittently controlling a field current that flows through a field coil (102) of said A.C. generator, said voltage adjusting device comprising:
a common circuit substrate for a first voltage system and a second voltage system which has an operating voltage higher than that in the first voltage system; and
a plurality of resistors (301c, 301d) printed on a circuit substrate on which an electric circuit for control is formed, said resistors being connected in parallel with each other between a plurality of conductors (A1, A2) on said circuit substrate;
wherein said plurality of resistors are used in a parallel connection state without being cut when said plurality of resistors are used for said first voltage system, whereas said plurality of resistors are used in a state where at least one (301d) of said resistors is cut when said plurality of resistors are used for said second voltage system so that said circuit substrate can be commonly used for said first voltage system and said second voltage system.

6. A voltage adjusting device (3) in which an output voltage of an A.C. generator (1) for charging a storage battery (6A) is adjusted to a given value by intermittently controlling a field current that flows in a field coil (102) of said A.C. generator, said voltage adjusting device comprising:
a common circuit substrate for a first voltage system and a second voltage system which has an operating voltage higher than that in the first voltage system; and
a plurality of resistors (301e, 301f) printed on said common circuit substrate on which an electric circuit for control is formed, said resistors being connected in series with each other between a plurality of conductors (A1, A2, A3) on said circuit substrate, said plurality of conductors being partially electrically connected by connection conductors (A4);
wherein said plurality of conductors are used in a series connection state without said connection conductors being cut when said plurality of conductors are used for said first voltage system, whereas said plurality of conductors are used in a state where at least a part of said connection conductor (A4) is cut when said plurality of conductors are used for said second voltage system so that said circuit substrate can be commonly used for said first voltage system and said second voltage system.
